# EUROPÄISCHE PATENTSCHRIFT

(11) **EP 1 456 947 B1**
(45) Veröffentlichungstag und Bekanntmachung des Hinweises auf die Patenterteilung: **30.03.2005**
(21) Anmeldenummer: 02777358.9
(22) Anmeldetag: 22.11.2002
(51) Int. Cl.: H03H 3/04

(54) **PIEZOELEKTRISCHER SCHWINGKREIS, VERFAHREN ZU DESSEN HERSTELLUNG UND FILTERANORDNUNG**
PIEZOELECTRICAL OSCILLATOR CIRCUIT METHOD FOR PRODUCTION THEREOF AND FILTER ARRANGEMENT
CIRCUIT OSCILLANT PIEZO-ELECTRIQUE, SON PROCEDE DE REALISATION ET SYSTEME DE FILTRE

(30) Priorität: 19.12.2001 DE 10162580
(43) Veröffentlichungstag der Anmeldung: 15.09.2004
(73) Patentinhaber: Infineon Technologies AG, 81669 München (DE)
(72) Erfinder: AIGNER, Robert, 82008 Unterhaching (DE); ELBRECHT, Lueder, 81825 München (DE); HANDTMANN, Martin, 81737 München (DE); MARKSTEINER, Stephan, 85579 Neubiberg (DE); NESSLER, Winfried, 81739 München (DE); TIMME, Hans-Joerg, 85521 Ottobrunn (DE)
(74) Vertreter: Schoppe, Fritz, Dipl.-Ing.
(86) Internationale Anmeldenummer: PCT/EP2002/013137
(87) Internationale Veröffentlichungsnummer: WO 2003/052928

(56) Entgegenhaltungen:
- US-A- 5 873 153
- US-A- 6 051 907
- US-B1- 6 249 074
- PATENT ABSTRACTS OF JAPAN vol. 004, no. 165 (E-034), 15. November 1980 (1980-11-15) & JP 55 115710 A (NIPPON DEMPA KOGYO CO LTD), 5. September 1980 (1980-09-05)
- PATENT ABSTRACTS OF JAPAN vol. 018, no. 038 (E-1495), 20. Januar 1994 (1994-01-20) & JP 05 267970 A (SUMITOMO METAL IND LTD), 15. Oktober 1993 (1993-10-15)

## Beschreibung

Die vorliegende Erfindung bezieht sich auf piezoelektrische Schwingkreise und hier insbesondere auf ein Verfahren zur Herstellung eines piezoelektrischen Schwingkreises in Dünnfilmtechnologie zur Einstellung einer vorbestimmten Eigenfrequenz des Schwingkreises. Ferner bezieht sich die vorliegende Erfindung auf Filteranordnungen, die so hergestellte piezoelektrische Schwingkreise umfassen.

Piezoelektrische Schwingkreise umfassen allgemein eine piezoelektrische Schicht, die zumindest teilweise zwischen gegenüberliegenden Elektroden angeordnet sind. Die Elektroden können Mehrschichtstrukturen oder Einschichtstrukturen sein. Die einzelnen Schichten eines piezoelektrischen Schwingkreises werden in Dünnfilmtechnologie hergestellt. Die Eigenfrequenz in solchen piezoelektrischen Schwingkreisen, die in Dünnfilmtechnologie hergestellt wurden, hängt stark von der Schichtdicke der einzelnen Schichten (Elektrodenschichten, piezoelektrische Schichten, etc.) ab. Die Abscheidegenauigkeit der in der Dünnschichttechnik verwendeten Verfahren, beispielsweise PVD, CVD, Aufdampfen, etc., liegt typischerweise bei (Max - Min)/Mittelwert = 10%. Die Schichtdicken variieren hierbei innerhalb des Substrats (Wafer) und von Substrat zu Substrat. Durch eine Optimierung der Abscheideprozesse kann diese Dickenstreuung auf etwa 2 bis 3% verbessert werden.

Für den Einsatz im NF-Bereich mag diese Genauigkeit ausreichen, jedoch werden piezoelektrische Schwingkreise vorzugsweise in Filtern von HF-Anwendungen bis in den GHz-Bereich angewendet. Eine beispielhafte Filterkonfiguration ist ein Bandpassfilter, welches unter anderem in mobilen Kommunikationsgeräten eingesetzt wird. Für solche Anwendungen liegt die erforderliche Genauigkeit bei der Dünnfilmtechnologie unter 0,1% (Max - Min) für die Lage der Eigenfrequenz.

Um die für den HF-Bereich erforderliche Genauigkeit der Frequenzlage zu erreichen, ist ein Verfahren zur Herstellung einer Schicht mit einem vorgegebenen Schichtdickenprofil bekannt. Hierbei wird auf einem Substrat nach Abscheidung der piezoelektrischen Schwingkreise die Eigenfrequenz an mehreren Positionen des Substrats/Wafers durch Messung bestimmt, und aus der Abweichung der gemessenen Frequenz von der spezifizierten Zielfrequenz wird eine erforderliche Dünnung einer obersten Schicht der einzelnen piezoelektrischen Schwingkreise festgelegt. Diese Dünnung wird in diesem Verfahren durch ein lokales Absputtern der obersten Schicht mit einem Ionenstrahl erreicht. Der Ionenstrahl hat einen Durchmesser von ca. 10 mm, was deutlich größer ist als der Durchmesser eines einzelnen piezoelektrischen Schwingkreises (Bauelement), der bei etwa 1 mm liegt, aber ist deutlich kleiner als der Durchmesser des Wafers (Substrat), der bei etwa 50-200 mm liegt. Ein auf dem Wafer lokal unterschiedlicher Abtrag gemäß der erforderlichen Frequenzkorrektur wird durch Abrastern des Strahls über das Substrat mit lokal unterschiedlicher Ätzrate und/oder Geschwindigkeit erreicht.

Dieses bekannte Verfahren wird lediglich auf eine oberste Schicht des erzeugten und fertig gestellten Dünnschicht-Schwingkreises angewandt, und aufgrund der Tatsache, dass dieses Verfahren ausschließlich einmal nach vollständiger Fertigstellung des piezoelektrischen Schwingkreises auf diese oberste Schicht angewandt wird, ergeben sich die folgenden Anforderungen an die oberste Schicht sowie an die Reproduzierbarkeit und Genauigkeit des Ätzschrittes.

Die Abscheidungen aller im piezoelektrischen Schwingkreis enthaltenen Schichten ergeben eine Streuung der Eigenfrequenz aller produzierten Schwingkreise von (Max - Min)/Mittelwert = 10%. Um diese Streuung vollständig korrigieren zu können, muss der Mittelwert durch entsprechenden Vorhalt bei der Abscheidung so gelegt werden, dass die Eigenfrequenz aller erzeugten piezoelektrischen Schwingkreise (Bauelemente) unterhalb der spezifizierten Zielfrequenz liegt, da durch das Abätzen der obersten Schicht nur eine Korrektur der Eigenfrequenz nach oben erfolgen kann.

Ferner muss die oberste Schicht ausreichend dick sein, so dass eine Verschiebung der Eigenfrequenz um 10% durch Dünnen möglich ist, ohne diese Schicht vollständig zu entfernen. Dies hat zur Folge, dass die piezoelektrischen Schwingkreise nach der Korrektur dann zwar nur eine minimale Streuung in der Frequenzverteilung aufweisen, jedoch die Dicke der obersten Schicht beträchtlich streut, da alle Dickenfehler des gesamten Schichtstapels durch die oberste Schicht auskorrigiert werden müssen. Dies bewirkt eine starke Streuung anderer charakteristischer Eigenschaften der piezoelektrischen Schwingkreise, wie z. B. die piezoelektrische Kopplung, die Anregung unerwünschter Lateralmoden oder elektrische Verluste.

Eine weitere Anforderung, die sich aus dem oben bekannten Verfahren ergibt, betrifft die Genauigkeit des Ätzprozesses. Um eine Frequenzverteilung mit einer Breite von 10% in einem Zielfenster von 0,1% zu treffen, muss der Ätzprozess eine relative Genauigkeit und Reproduzierbarkeit von besser als 1% aufweisen. Diese Anforderung ergibt sich nicht nur für die Ätzrate des Prozesses, also den Abtrag der obersten Schicht in Nanometern, sondern auch für den Zusammenhang welche Frequenzverschiebung ein vorgegebener Dickenabtrag bewirkt. Nur wenn beide Werte, die Ätzrate in nm/sek und die Frequenzänderungsrate in MHz/nm, besser als auf 1% genau bekannt und stabil sind, kann der oben beschriebene lokale Ätzschritt alle piezoelektrischen Schwingkreise in einem Prozessschritt in das spezifizierte Frequenzfenster bringen.

Das Problem bei dem oben beschriebenen Verfahren besteht jedoch darin, dass es ausgesprochen schwierig ist, die beiden relevanten Parameter, die Ätzrate und die Frequenzänderungsrate, mit einer Genauigkeit von unter 1% für jeden Wafer zu bestimmen.

Ausgehend von diesem Stand der Technik liegt der vorliegenden Erfindung die Aufgabe zugrunde, ein verbessertes Verfahren zur Herstellung eines piezoelektrischen Schwingkreises zu schaffen, das eine genaue Einstellung der Eigenfrequenz des piezoelektrischen Schwingkreises bei gleichzeitiger Absenkung der Anforderungen an die Genauigkeit des Korrekturverfahrens ermöglicht.

Diese Aufgabe wird durch ein Verfahren nach Anspruch 1 gelöst.

Gemäß einem weiteren Aspekt der vorliegenden Erfindung wird ein piezoelektrischer Schwingkreis geschaffen, der nach dem erfindungsgemäßen Verfahren hergestellt wurde. Gemäß einem wiederum weiteren Aspekt der vorliegenden Erfindung wird eine Filteranordnung geschaffen, die einen oder mehrere piezoelektrische Schwingkreise die nach dem erfindungsgemäßen Verfahren hergestellt wurden umfassen.

Der vorliegenden Erfindung liegt die Erkenntnis zugrunde, dass die oben erwähnte Schwierigkeit, die zwei für die Frequenzkorrektur relevanten Parameter, nämlich die Ätzrate und die Frequenzänderungsrate, mit einer Genauigkeit von unter 1% für jeden Wafer zu bestimmen, dadurch vermieden werden kann, dass ein erweitertes, mehrstufiges Ätzverfahren verwendet wird, wodurch sich die Genauigkeitsanforderungen für jeden der Ätzschritte deutlich reduzieren lassen. Erfindungsgemäß wird die Frequenzkorrektur anders als bei dem oben beschriebenen Verfahren, bei der Herstellung von piezoelektrischen Schwingkreisen in Dünnschichttechnologie stufenweise durch mehrere, gegebenenfalls lokale Ätzschritte in Schichten mit unterschiedlicher Frequenzänderungsrate durchgeführt, wodurch die Genauigkeitsanforderungen für jeden einzelnen Ätzschritt deutlich reduziert werden können.

Gemäß einem bevorzugten Ausführungsbeispiel der vorliegenden Erfindung wird bei dem Herstellungsprozess eines piezoelektrischen Schwingkreises nach dem Abscheiden einer bestimmten Schicht, welche nicht zwingend die obere Schicht oder oberste Schicht des fertiggestellten piezoelektrischen Schwingkreises sein muss, die Eigenfrequenz des bis dahin entstandenen piezoelektrischen Schwingkreises gemessen und mit einer Zielfrequenz für diesen, gegebenenfalls nicht fertig gestellten piezoelektrischen Schwingkreis verglichen. Im Zusammenhang mit dieser Berechnung kann auch noch die zusätzliche Frequenzverschiebung einfließen, die sich durch die Abscheidung der verbleibenden Schichten der geplanten Dicke ergeben wird. Es ist festzuhalten, dass die Zielfrequenz des halb fertiggestellten piezoelektrischen Schwingkreises im Regelfall höher ist als die Zielfrequenz des fertigen piezoelektrischen Schwingkreises, da die zusätzlichen Schichten die Eigenfrequenz stets nach unten verändern.

Durch Vergleich der gemessenen Eigenfrequenz mit der berechneten Zielfrequenz, entweder für den fertiggestellten piezoelektrischen Schwingkreis oder für den teilweise fertiggestellten piezoelektrischen Schwingkreis, kann dann eine Korrektur definiert werden. Diese Korrektur erfolgt gemäß einem bevorzugten Ausführungsbeispiel durch ein lokales Absputtern der oben liegenden Schicht des gegebenenfalls halbfertigen piezoelektrischen Schwingkreises unter Verwendung eines Ionenstrahls, also durch ein lokales Ätzverfahren an der Stelle in dem Herstellungsprozess, an der auch die Eigenfrequenz des bis zu dieser Stelle im Prozess entstandenen piezoelektrischen Schwingkreises gemessen wurde. Nach dieser ersten Korrektur werden die verbleibenden Schichten auf dem existierenden piezoelektrischen Schwingkreis bzw. dem halb fertiggestellten piezoelektrischen Schwingkreis abgeschieden. Anschließend wird die Eigenfrequenz erneut bestimmt, und das lokale Ätzverfahren wird in der obersten Schicht des nunmehr fertiggestellten piezoelektrischen Schwingkreises nochmals wiederholt.

Der Vorteil dieses erfindungsgemäßen, mehrstufigen Verfahrens besteht darin, dass durch die erste, grobe Frequenzkorrektur bereits ein Großteil der Frequenzschwankungen durch Schichtdickenfehler korrigiert wird und damit der Gesamtbetrag, der bei der letzten Korrekturätzung in der obersten Schicht des fertiggestellten piezoelektrischen Schwingkreises wegzuätzen ist, deutlich geringer ist. Einerseits kann hierdurch die Dickenverteilung der obersten Schicht bei der Herstellung einer Mehrzahl von piezoelektrischen Schwingkreisen auf einem Wafer deutlich schmaler gehalten werden, so dass die Schwingkreise in ihren Eigenschaften wesentlich homogener sind. Andererseits wirkt sich ein relativer Fehler in Ätzrate oder der Frequenzänderungsrate nicht mehr so stark aus wie bei dem oben beschriebenen einstufigen Verfahren gemäß dem Stand der Technik.

Der Vorteil der vorliegenden Erfindung besteht darin, dass im Gegensatz zu dem oben beschriebenen Verfahren aus dem Stand der Technik, welches ein lokales Ätzen durch Frequenzkorrektur von piezoelektrischen Schwingkreisen in Dünnfilmtechnologie lehrt, die vorliegende Erfindung ein verbessertes Verfahren schafft, bei dem ein zwei- oder mehrstufiges Verfahren zur Frequenzkorrektur eingesetzt wird, wobei erfindungsgemäß zunächst eine grobe Korrektur in einer Schicht mit einer großen Frequenzänderungsrate erfolgt, und anschließend eine Feinkorrektur in einer nach der ersten Korrektur abgeschiedenen anderen Schicht mit niedriger Frequenzänderungsrate erfolgt. Dies führt zu einer starken Reduzierung der Streuung der Dicken jener Schichten, die für die Korrektur verwendet werden, und die Anforderungen an die Genauigkeit des Korrekturverfahrens lassen sich gemäß einem Ausführungsbeispiel fast um den Faktor 10 absenken.

Bevorzugte Weiterbildungen der vorliegenden Anmeldung sind in den Unteransprüchen definiert.

Nachfolgend werden anhand der beiliegenden Figuren bevorzugte Ausführungsbeispiele der vorliegenden Erfindung näher erläutert. Es zeigen:

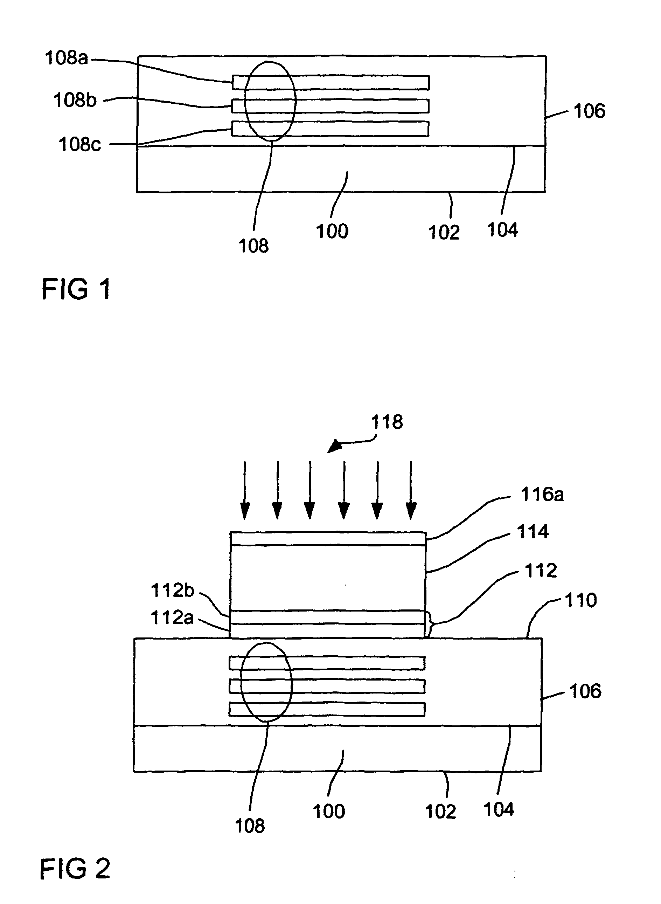

Fig. 1 bis 3 ein Ausführungsbeispiel für das erfindungsgemäße Herstellungsverfahren eines piezoelektrischen Schwingkreises mit vorbestimmter Eigenfrequenz.

Die Fig. 1 bis 3 zeigen beispielhaft die unterschiedlichen Strukturen, welche sich nach verschiedenen Herstellungsschritten eines Prozessablaufs zur Herstellung piezoelektrischer Schwingkreise in Dünnfilmtechnologie gemäß der vorliegenden Erfindung ergeben.

In Fig. 1 ist eine Struktur dargestellt, wie sie sich nach einem ersten Herstellungsabschnitt ergibt. In diesem Herstellungsabschnitt wird zunächst ein Trägersubstrat 100 bereitgestellt, welches beispielsweise ein Silizium-Wafer, ein Glasträger oder andere geeignete Substrate umfasst. Das Trägersubstrat 100 umfasst eine erste, untere Oberfläche 102 sowie eine zweite, der unteren Oberfläche 102 gegenüberliegende obere Oberfläche 104. Auf die obere Oberfläche 104 des Substrats 100 wird eine akustische Isolationsschicht 106 aufgebracht, in der ein akustischer Isolator 108 angeordnet ist, der verhindert, dass eine akustische Schwingung eines nachfolgend aufgebrachten piezoelektrischen Schwingkreises in das Substrat 100 entweichen kann. Bei dem in Fig. 1 beschriebenen Ausführungsbeispiel ist der akustische Isolator 108 durch einen akustischen Reflektor gebildet, der eine Mehrzahl von Schichten 108a bis 108c mit abwechselnd hoher und niedriger akustischer Impedanz aufweist. Alternativ kann anstelle des akustischen Reflektors 108 auch ein Hohlraum in der akustischen Isolationsschicht 106 gebildet sein, welcher die gleiche Wirkung hat, wie der akustische Reflektor. Anstelle der akustischen Isolationsschicht 106 kann auch das Substrat 100 mit einem Membranbereich versehen sein, auf dem nachfolgend der piezoelektrische Schwingkreis aufgebaut wird, so dass der unter dem Membranbereich in dem Substrat definierte Hohlraum für die erforderlich akustische Entkopplung von Schwingkreis und Substrat sorgt.

In einem nachfolgenden Herstellungsabschnitt, dessen Endstruktur in Fig. 2 gezeigt ist, wird auf einer oberen Oberfläche 110 der akustischen Isolationsschicht 106 zumindest teilweise eine Bodenelektrode 112 abgeschieden. Die Bodenelektrode 112 kann eine einschichtige Elektrode sein, oder sie kann, wie bei dem in Fig. 2 gezeigten Ausführungsbeispiel eine mehrschichtige Elektrode sein, die hier an eine erste Bodenelektrodenschicht 112a sowie eine zweite Bodenelektrodenschicht 112b umfasst. Zumindest eine der Bodenelektrodenschichten 112a, 112b ist elektrisch leitend. Ferner kann die Bodenelektrode 112 weitere Schichten (in Fig. 2 nicht gezeigt) umfassen, die zur Verbesserung der akustischen Eigenschaften dienen und/oder prozessbedingt notwendig sind, wie z. B. eine Haftvermittlungsschicht, ein sogenannter Seeding-Layer, etc.

Wie in Fig. 2 zu erkennen ist, ist die erste Bodenelektrodenschicht 112a zumindest auf einem Abschnitt der oberen Oberfläche 110 der akustischen Isolationsschicht 106 abgeschieden, und auf der dem Substrat 100 abgewandten Oberfläche der ersten Bodenelektrodenschicht 112a ist die zweite Bodenelektrodenschicht 112b gebildet.

Auf der dem Substrat 100 abgewandten Oberfläche der zweiten Bodenelektrodenschicht 112b ist eine piezoelektrische Schicht 114 abgeschieden, auf der wiederum in nachfolgenden Prozessen eine obere Elektrode abgeschieden wird, die aus einer Einzelschicht bestehen kann, oder aus mehreren Einzelschichten bestehen kann, wobei auch hier zumindest eine dieser Schichten elektrisch leitend ist. Gemäß dem beschriebenen Ausführungsbeispiel wird jedoch zunächst, wie in Fig. 2 gezeigt ist, nur eine erste, obere Elektrodenschicht 116a abgeschieden. Nun wird die Eigenfrequenz des bis zu diesem Prozessabschnitt fertiggestellten Teil-Schwingkreises bestimmt und mit einer erwünschten Zielfrequenz verglichen. Die piezoelektrische Schicht 114 ist aus einem geeigneten piezoelektrischen Material, wie beispielsweise Aluminiumnitrid (AlN), Zinkoxid (ZnO), oder Blei-Zirkonium-Titanat (PZT) hergestellt.

Die Messung der Eigenfrequenz des teilweise fertiggestellten piezoelektrischen Schwingkreises, wie er beispielsweise in Fig. 2 gezeigt ist, kann nun auf unterschiedlichen Wegen erfolgen.

Eine erste Möglichkeit besteht darin, dass der teilweise fertiggestellte piezoelektrische Schwingkreis, wie auch in Fig. 2 gezeigt, bereits vor der ersten Korrektur eine elektrisch leitende obere Elektrode, in Fig. 2 die erste obere Elektrodenschicht 116a, umfasst. Ist der piezoelektrische Schwingkreis so weit hergestellt, so ermöglicht dies, nach Abscheidung dieser elektrisch leitenden Schicht 116a diese so zu strukturieren, dass der piezoelektrische Schwingkreis, oder einige piezoelektrische Schwingkreise, die auf einem Wafer hergestellt wurden, elektrisch kontaktierbar und damit messbar sind. Aus der sich ergebenden Impedanzkurve kann, in Abhängigkeit der Frequenz, die Eigenfrequenz bestimmt werden.

Eine zweite Möglichkeit besteht darin, den teilweise fertiggestellten piezoelektrischen Schwingkreis auf andere als elektrische Weise anzuregen, z. B. durch einen gepulsten Laser. Dies ist dann erforderlich, wenn noch keine elektrisch leitende Schicht für eine entsprechende elektrische Anregung des Schwingkreises vorliegt. In diesem Fall kann durch Beobachtung der Ausbreitung der durch den gepulsten Laser induzierten akustischen Schwingung die Eigenfrequenz des Schwingkreises bestimmt werden, beispielsweise aus der zeitlichen Verzögerung des Echos der Anregung von tiefer liegenden Schichten.

Ferner kann eine Frequenzkorrektur auch dann durchgeführt werden, wenn die Eigenresonanz des teilweise fertiggestellten piezoelektrischen Schwingkreises nicht durch Messung bestimmt werden kann. In diesem Fall wird die Eigenfrequenz dadurch bestimmt, dass die Schichtdicken aller bis dahin abgeschiedenen Schichten des piezoelektrischen Schwingkreises genau vermessen werden, was jedoch eine sehr hohe Messgenauigkeit aller dieser Schichten sowie eine genaue Bestimmung und Reproduzierbarkeit der akustischen Parameter aller bisher verwendeten Schichten voraussetzt. Aufgrund der so gewonnenen Informationen über die Schichten kann dann die Eigenresonanz berechnet werden und hieraus eine Korrektur abgeleitet werden.

Nachdem auf die gerade beschriebene Art und Weise die Eigenfrequenz des piezoelektrischen Schwingkreises, der die in Fig. 2 gezeigte, teilweise fertiggestellte Struktur aufweist, bestimmt wurde, und mit einer erwünschten Zielfrequenz verglichen wurde, kann hieraus die erforderliche Korrektur abgeleitet werden. Es wird hierbei bestimmt, auf welchen Wert die Dicke der oberen Schicht 116a eingestellt werden muss. Mittels eines lokalen Ätzvorgangs, der in Fig. 2 durch die Pfeile 118 angedeutet ist, wird die Dicke der ersten oberen Elektrodenschicht 116a auf einen bestimmten Wert eingestellt.

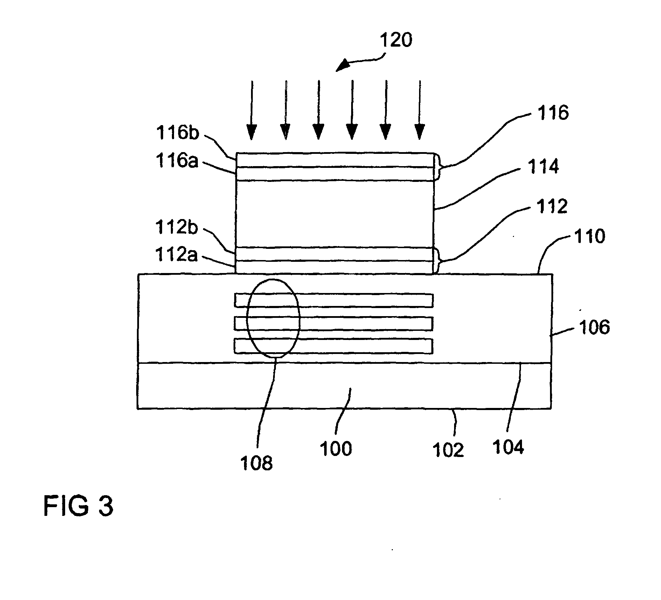

Nachdem die Schichtdicke der ersten oberen Elektrodenschicht 116a auf den erwünschten Wert eingestellt wurde, erfolgt die Abscheidung der, in dem beschriebenen Ausführungsbeispiel letzten Schicht zur Fertigstellung des piezoelektrischen Schwingkreises. Wie in Fig. 3 gezeigt ist, wird auf die erste obere Elektrodenschicht 116a eine zweite obere Elektrodenschicht 116b abgeschieden, so dass durch die zwei oberen Elektrodenschichten die obere Elektrode 116 gebildet ist. Anschließend erfolgt erneut eine Bestimmung der Eigenfrequenz des nunmehr fast fertiggestellten piezoelektrischen Schwingkreises auf eine der oben beschriebenen Arten, und abhängig von der bestimmten Eigenfrequenz wird eine erforderliche Dünnung der zweiten oberen Elektrodenschicht 116b festgelegt, welche dann mittels eines lokalen Ätzvorgangs, der durch die Pfeile 120 angedeutet ist, eingestellt wird.

Der Vorteil des gerade beschriebenen Verfahrens zur Herstellung eines piezoelektrischen Schwingkreises besteht darin, dass, insbesondere bei einer Herstellung einer Mehrzahl von piezoelektrischen Schwingkreisen auf einem Wafer die Schichtdickenverteilung der obersten Schicht, der oberen Elektrode 116 nahezu 10 mal schärfer ist als mit einem einstufigen Verfahren.

Ein weiterer Vorteil der vorliegenden Erfindung besteht darin, dass die Anforderungen an die Genauigkeit der lokalen Ätzprozesse um den Faktor 10 reduziert werden, wie dies nachfolgen kurz erläutert sei. Bei einer Frequenzabweichung von 10% vor dem ersten lokalen Ätzschritt 118 und einer relativen Genauigkeit dieses lokalen Ätzverfahrens 118 von 10%, kann die berechnete Zielfrequenz im Rahmen dieser ersten Frequenzkorrektur auf etwa 1% genau getroffen werden. Die weiteren Schichten, die zur Fertigstellung des piezoelektrischen Schwingkreises erforderlich sind, können dann so gewählt werden, dass ihr Einfluss auf die Frequenzstreuung selbst bei einer Schichtdickenschwankung dieser Schichten von 10% kleiner als 1% bleibt. Dies wird dadurch erreicht, dass man Materialien mit einer kleinen Frequenzänderungsrate wählt, und davon nur dünne Schichten abscheidet. So wird die bereits erreichte Schärfe der Frequenzverteilung von 1% durch die Abscheidung der letzten Schichten, bei dem anhand der Figuren beschriebenen Ausführungsbeispiel der letzten Schicht 116b nicht wesentlich verschlechtert. Nach Abscheidung der letzten Schicht wird die Frequenzverteilung wiederum durch lokales Ätzen 120 korrigiert, wobei die maximale Abweichung von der Zielfrequenz jetzt nur noch 1% beträgt. Der notwendige Vorhalt und maximale Abdünnung sind also 10 mal geringer als im Fall eines einstufigen Verfahrens. Der lokale Ätzprozess wird nochmals mit einer Genauigkeit von 10% angewandt, so dass damit eine Zielgenauigkeit der Endfrequenz erreichbar ist, die der spezifizierten Genauigkeit von 0,1% entspricht.

Es sei darauf hingewiesen, dass die vorliegende Erfindung natürlich nicht auf das oben anhand der Figuren beschriebene zweistufige Korrekturverfahren beschränkt ist, sondern dass auch drei oder mehr Korrekturschritte verwendet werden können.

Beispielhaft sei nun ein piezoelektrischer Schwingkreis mit einer erwünschten Eigenfrequenz von etwa 2 GHz betrachtet. In diesem Fall eignet sich für die obere Elektrode 116 eine zweischichtige Struktur, wie sie oben anhand der Figuren beschrieben wurde, wobei die erste obere Elektrodenschicht 116a aus einem akustischen dichteren Material, wie z. B. Wolfram, hergestellt ist, und wobei die zweite obere Elektrodenschicht 116b aus einem akustisch weniger dichten Material, wie z. B. Aluminium, hergestellt ist. Die erste Korrektur (siehe Fig. 2) erfolgt nach Abscheidung der Wolframschicht 116a, in der die Frequenzänderungsrate groß ist, etwa 3 MHz/nm. In dieser Schicht ist eine Korrektur um bis zu 10% der Zielfrequenz, was bei dem gewählten Ausführungsbeispiel einer Frequenzkorrektur um 200 MHz entspricht, mit verhältnismäßig geringen Materialabtrag (maximal 66 nm) möglich, wodurch sich zusätzlich eine geringe Bearbeitungszeit ergibt. Die Abscheidung der Aluminiumschicht 116b (siehe Fig. 3) des oberen Elektrodenstapels 116 bewirkt trotz des Schichtdickenfehlers bei der Aluminiumabscheidung nur eine geringe oder gar keine Aufweitung der Frequenzverteilung, da bei dieser Schicht 116b die Frequenzänderungsrate klein ist, etwa 0,5 MHz/nm. Sehr kleine Frequenzkorrekturen, maximal 20 MHz, können hier durch Abtrag von maximal 40 nm Aluminium erreicht werden.

Werden eine Vielzahl von piezoelektrischen Schwingkreisen gleichzeitig auf einem Wafer hergestellt, so kann bei einer Abscheidung von Aluminium mit einer Dicke von 300 nm als oberste Elektrodenschicht 116b erreicht werden, dass alle korrigierten piezoelektrischen Schwingkreise auf einem Wafer eine Aluminiumschichtdicke zwischen 260 nm und 300 nm aufweisen. Für die Frequenzverteilung nach dem zweiten Ätzvorgang 120 bedeuten Prozessschwankungen von etwa 10% eine Breite von (Max - Min)/Mittelwert = 2 MHz, was der erforderten Genauigkeit von 0,1% entspricht.

Bei dem oben beschriebenen, herkömmlichen einstufigen Verfahren müsste eine Frequenzstreuung von 200 MHz in der obersten Aluminiumschicht alleine korrigiert werden, was bedeutet, dass eine Aluminiumschicht mit einer Dicke von etwa 600nm abgeschieden werden müsste. Der Grund hierfür besteht darin, dass eine Schichtdicke von 200 nm Aluminium mindestens erforderlich ist, um eine ausreichende elektrische Leitfähigkeit zu erreichen, und weitere 400nm als Vorhalt notwendig sind, um eine Streuung von 200MHz auszugleichen. Da auf einigen Systemen gar kein Abtrag erforderlich sein wird, auf anderen jedoch eine Korrektur von 200 MHz, werden bei diesen Prozessen piezoelektrische Schwingkreise mit einer Schichtdicke der obersten Schicht mit 600 nm und andere piezoelektrische Schichtkreise mit einer Dicke von 200 nm entstehen. Diese extremen piezoelektrischen Schwingkreise werden sich in den effektiven piezoelektrischen Kopplungsfaktoren um etwa 10% unterscheiden.

Diese Problematik wird durch den erfindungsgemäßen zweistufigen Ätzprozess vermieden.

Obwohl oben bevorzuge Beispiele für das erfindungsgemäße Verfahren zur Frequenzkorrektur beschrieben wurden, bei denen stets von den aufgebrachten Schichten ein Teil abgetragen (gedünnt) wurde, ist die vorliegende Erfindung nicht hierauf beschränkt. Basierend auf die oben beschriebenen Prinzipien lässt sich eine zwei- oder mehrstufige Frequenzkorrektur auch dadurch erreichen, dass einzelne oder alle Schichten im Rahmen der erfindungsgemäßen Bearbeitung der Schicht zur Frequenzkorrektur ein Vergrößerung der Dicke erfahren.

### Bezugszeichenliste

- 100: Substrat
- 102: untere Oberfläche des Substrats
- 104: obere Oberfläche des Substrats
- 106: akustische Isolatorschicht
- 108: akustischer Isolator
- 108a - 108b: Schichten des akustischen Isolators
- 110: obere Oberfläche der Isolatorschicht
- 112: Bodenelektrode
- 112a: erste Bodenelektrodenschicht
- 112b: zweite Bodenelektrodenschicht
- 114: piezoelektrische Schicht
- 116: obere Elektrode
- 116a: erste obere Elektrodenschicht
- 116b: zweite obere Elektrodenschicht
- 118: Ätzvorgang
- 120: Ätzvorgang

## Patentansprüche

1. Verfahren zur Herstellung eines piezoelektrischen Schwingkreises in Dünnfilmtechnologie, wobei der piezoelektrische Schwingkreis eine vorbestimmte Eigenfrequenz aufweist, und wobei der piezoelektrische Schwingkreis eine piezoelektrische Schicht (114) mit zwei gegenüberliegenden Oberflächen, eine untere Elektrode (112; 112a, 112b) auf einer der gegenüberliegenden Oberflächen und eine obere Elektrode (116a, 116b) auf der anderen der gegenüberliegenden Oberflächen umfasst, wobei das Verfahren folgende Schritte aufweist:
(a) Erzeugen zumindest einer ersten oberen Elektrodenschicht (116a) der oberen Elektrode;
(b) Durchführen einer ersten Frequenzkorrektur durch Verringern oder Vergrößern der Dicke der im Schritt (a) erzeugten ersten oberen Elektrodenschicht (116a);
(c) Erzeugen zumindest einer zweiten oberen Elektrodenschicht (116b) auf der ersten oberen Elektrodenschicht (116a); und
(d) Durchführen einer zweiten Frequenzkorrektur durch Verringern oder Vergrößern der Dicke der im Schritt (c) erzeugten zweiten oberen Elektrodenschicht (116b).

2. Verfahren nach Anspruch 1, bei dem die erste Frequenzkorrektur im Schritt (b) eine Grobeinstellung der Frequenz bewirkt, und bei dem die zweite Frequenzkorrektur im Schritt (c) eine Feineinstellung der Frequenz bewirkt.

3. Verfahren nach Anspruch 1 oder 2, bei dem die im Schritt (a) erzeugte erste obere Elektrodenschicht (116a) aus einem Material hergestellt ist, das abhängig von einer Dickenänderung der ersten oberen Elektrodenschicht (116a) eine große Frequenzänderung des piezoelektrischen Schwingkreises bewirkt, und bei dem die im Schritt (c) erzeugte zweite obere Elektrodenschicht (116b) aus einem Material hergestellt ist, das abhängig von einer Dickenänderung der zweiten oberen Elektrodenschicht (116b) eine kleine Frequenzänderung des piezoelektrischen Schwingkreises bewirkt.

4. Verfahren nach einem der Ansprüche 1 bis 3, bei dem die erste Frequenzkorrektur und die zweite Frequenzkorrektur ein Ätzen der ersten oberen Elektrodenschicht (116a) und der zweiten oberen Elektrodenschicht (116b) umfasst.

5. Verfahren nach einem der Ansprüche 1 bis 4, mit folgenden Schritten nach dem Schritt (a) und nach dem Schritt (b):
Bestimmen der Eigenfrequenz der sich nach dem Schritt (a) bzw. nach dem Schritt (b) ergebenden Struktur; und
abhängig von der bestimmten Eigenfrequenz der Struktur und abhängig von der erwünschten Eigenfrequenz des piezoelektrischen Schwingkreises, Festlegen einer erforderlichen Dickenänderung der ersten oberen Elektrodenschicht (116a) und der zweiten oberen Elektrodenschicht (116b) für die erste Frequenzkorrektur und für die zweite Frequenzkorrektur.

6. Verfahren nach einem der Ansprüche 1 bis 5, mit folgenden Schritten:
(e) Erzeugen zumindest einer dritten oberen Elektrodenschicht auf der zweiten oberen Elektrodenschicht (116b); und
(f) Durchführen einer dritten Frequenzkorrektur durch Verringern oder Vergrößern der Dicke der im Schritt (e) erzeugten dritten oberen Elektrodenschicht.

7. Verfahren nach einem der Ansprüche 1 bis 6, bei dem der Schritt (a) folgende Schritte umfasst:
(a.1.) Bereitstellen eines Substrats (100);
(a.2.) Erzeugen der unteren Elektrode (112) auf zumindest einem Abschnitt des Substrats (100);
(a.3.) Erzeugen der piezoelektrischen Schicht (114) auf zumindest einem Abschnitt der unteren Elektrode (114); und
(a.4.) Erzeugen der ersten oberen Elektrodenschicht (116a) für die obere Elektrode (116) auf zumindest einem Abschnitt der piezoelektrischen Schicht (114).

8. Verfahren nach Anspruch 7, bei dem der Schritt (a.1.) das Erzeugen eines akustischen Isolators (108) auf oder in dem Substrat (100) umfasst, um ein Entweichen der akustischen Schwingung in das Substrat (100) zu vermeiden.

9. Verfahren nach Anspruch 7 oder 8, bei dem'die untere Elektrode (112) eine einschichtige oder eine mehrschichtige Elektrode (112a, 112b) ist.

10. Verfahren nach einem der Ansprüche 7 bis 9, bei dem die erste obere Elektrodenschicht (116a) aus einem akustisch dichten Material hergestellt ist, und bei dem die zweite obere Elektrodenschicht (116b) aus einem Material hergestellt ist, dessen akustische Dichte verglichen mit dem Material der ersten oberen Elektrodenschicht (116a) geringer ist.

11. Verfahren nach Anspruch 10, bei dem die obere Elektrode (116) und/oder die untere Elektrode (112) aus Aluminium und/oder Wolfram hergestellt sind.

12. Verfahren nach einem der Ansprüche 1 bis 11, bei dem eine Mehrzahl von piezoelektrischen Schwingkreisen auf einem Wafer erzeugt wird, wobei im Schritt (a) auf dem Wafer die zumindest eine erste obere Elektrodenschicht (116a) für eine Anzahl der piezoelektrischen Schwingkreise strukturiert erzeugt wird, wobei im Schritt (b) die erste Frequenzkorrektur auf den gesamten Wafer angewendet wird, wobei im Schritt (c) die zumindest eine zweite obere Elektrodenschicht (116b) für alle piezoelektrischen Schwingkreise strukturiert erzeugt wird, und wobei im Schritt (d) die zweite Frequenzkorrektur auf den gesamten Wafer angewendet wird.

13. Verfahren nach Anspruch 12, bei dem die erste Frequenzkorrektur und die zweite Frequenzkorrektur das schrittweise Bearbeiten verschiedener Bereiche des Wafers umfasst.

14. Piezoelektrischer Schwingkreis, der nach einem Verfahren nach einem der Ansprüche 1 bis 13 hergestellt wurde.

15. Filteranordnung mit einem oder mehreren piezoelektrischen Schwingkreisen nach Anspruch 14.

## Claims

1. Method for manufacturing a piezoelectric oscillating circuit in thin film technology, wherein the piezoelectric oscillating circuit comprises a predetermined natural frequency, and wherein the piezoelectric oscillating circuit includes a piezoelectric layer (114) having two opposing surfaces, a bottom electrode (112; 112a, 112b) on one of the opposing surfaces and a top electrode (116a, 116b) on the other of the opposing surfaces, the method comprising:
(a) generating at least one first top electrode layer (116a) of the top electrode;
(b) performing a first frequency correction by reducing or increasing the thickness of the first top electrode layer (116a) generated in step (a);
(c) generating at least one second top electrode layer (116b) on the first top electrode layer (116a); and
(d) performing a second frequency correction by reducing or increasing the thickness of the second top electrode layer (116a) generated in step (c).

2. Method according to claim 1, wherein the first frequency correction in step (b) causes a coarse setting of the frequency, and wherein the second frequency correction in step (c) causes a fine setting of the frequency.

3. Method according to claim 1 or 2, wherein the first top electrode layer (116a) generated in step (a) is manufactured from a material which causes a great frequency change of the piezoelectric oscillating circuit depending on a thickness change of the first top electrode layer (116a), and wherein the second top electrode layer (116b) generated in step (c) is manufactured from a material which causes a small frequency change of the piezoelectric oscillating circuit depending on a thickness change of the second top electrode layer (116b).

4. Method according to one of claims 1 to 3, wherein the first frequency correction and the second frequency correction include an etching of the first top electrode layer (116a) and the second top electrode layer (116b).

5. Method according to one of claims 1 to 4, including the following steps after step (a) and after step (b):
determining the natural frequency of the structure resulting after step (a) and after step (b), respectively; and
depending on the determined natural frequency of the structure and depending on the desired natural frequency of the piezoelectric oscillating circuit, determining a required thickness change of the first top electrode layer (116a) and the second top electrode layer (116b) for the first frequency correction and for the second frequency correction.

6. Method according to one of claims 1 to 5, comprising the following steps:
(e) generating at least a third top electrode layer on the second top electrode layer (116b); and
(f) performing a third frequency correction by reducing or increasing the thickness of the third top electrode layer generated in step (e).

7. Method according to one of claims 1 to 6, wherein step (a) includes the following steps:
(a.1.) providing a substrate (100);
(a.2.) generating the bottom electrode (112) on at least one portion of the substrate (100);
(a.3.) generating the piezoelectric layer (114) on at least one portion of the bottom electrode (114); and
(a.4.) generating the first top electrode layer (116a) for the top electrode (116) on at least one portion of the piezoelectric layer (114).

8. Method according to claim 7, wherein step (a.1.) includes generating an acoustic insulator (108) on or in the substrate (100) in order to prevent a leaking of the acoustic oscillation into the substrate (100).

9. Method according to claim 7 or 8, wherein the bottom electrode (112) is a single-layer or a multi-layer electrode (112a, 112b).

10. Method according to one of claims 7 to 9, wherein the first top electrode layer (116a) is manufactured from an acoustically dense material, and wherein the second top electrode layer (116b) is manufactured from a material whose acoustic density is lower compared to the material of the first top electrode layer (116a).

11. Method according to claim 10, wherein the top electrode (116) and/or the bottom electrode (112) are manufactured from aluminum and/or tungsten.

12. Method according to one of claims 1 to 11, wherein a plurality of piezoelectric oscillating circuits are generated on a wafer, wherein in step (a) on the wafer the at least one first top electrode layer (116a) for a number of the piezoelectric oscillating circuits is generated in a structured way, wherein in step (b) the first frequency correction is applied to the overall wafer, wherein in step (c) the at least one second top electrode layer (116b) is generated for all piezoelectric oscillating circuits in a structured way, and wherein in step (d) the second frequency correction is applied to the overall wafer.

13. Method according to claim 12, wherein the first frequency correction and the second frequency correction include the step-wise processing of different areas of the wafer.

14. Piezoelectric oscillating circuit manufactured according to a method according to one of claims 1 to 13.

15. Filter arrangement having one or several piezoelectric oscillating circuits according to claim 14.

## Revendications

1. Procédé de production d'un circuit oscillant piézo-électrique en technologie à couche mince, dans lequel le circuit oscillant piézo-électrique a une fréquence propre déterminée à l'avance et dans lequel le circuit oscillant piézo-électrique comporte une couche (114) piézo-électrique ayant deux surfaces opposées, une électrode (112 ; 112a, 112b) inférieure sur l'une des surfaces opposées et une électrode (116a, 116b) supérieure sur l'autre des surfaces opposées, le procédé comprenant les stades suivants, dans lesquels:
(a) on produit au moins une première couche (116a) d'électrode supérieure de l'électrode supérieure ;
(b) on effectue une première correction de fréquence en diminuant ou en augmentant l'épaisseur de la première couche (116a) d'électrode supérieure produite au stade (a) ;
(c) on produit au moins une deuxième couche (116b) d'électrode supérieure sur la première couche (116a) d'électrode supérieure ;
(d) on effectue une deuxième correction de fréquence en diminuant ou en augmentant l'épaisseur de la deuxième couche (116b) d'électrode supérieure produite au stade (c).

2. Procédé suivant la revendication 1, dans lequel la première correction de fréquence au stade (b) donne un réglage grossier de la fréquence et dans lequel la deuxième correction de la fréquence au stade (c) donne un réglage fin de la fréquence.

3. Procédé suivant la revendication 1 ou 2, dans lequel on produit la première couche (116a) d'électrode supérieure produite au stade (a) en un matériau qui donne, en fonction d'une variation d'épaisseur de la première couche (116a) d'électrode supérieure, une grande variation de la fréquence du circuit oscillant piézo-électrique et dans lequel on produit la deuxième couche (116b) d'électrode produite au stade (c) en un matériau qui, en fonction d'une variation d'épaisseur de la deuxième couche (116b) d'électrode supérieure, donne une petite variation de fréquence du circuit oscillant piézo-électrique.

4. Procédé suivant l'une des revendications 1 à 3, dans lequel la première correction de fréquence et la deuxième correction de fréquence comprennent une attaque de la première couche (116a) supérieure et de la deuxième couche (116b) d'électrode supérieure.

5. Procédé suivant l'une des revendications 1 à 4, comprenant les stades suivants après le stade (a) et après le stade (b) :
détermination de la fréquence propre de la structure obtenue après le stade (a) ou après le stade (b) ; et
en fonction de la fréquence propre déterminée de la structure et en fonction de la fréquence propre souhaitée du circuit oscillant piézo-électrique, fixation d'une variation d'épaisseur nécessaire de la première couche (116a) d'électrode supérieure et de la deuxième couche (116b) d'électrode supérieure pour la première correction de fréquence et pour la deuxième correction de fréquence.

6. Procédé suivant l'une des revendications 1 à 5, comprenant les stades suivants, dans lesquels :
(e) on produit au moins une troisième couche d'électrode supérieure sur la deuxième couche (116b) d'électrode supérieure ; et
(f) on effectue une troisième correction de fréquence en diminuant ou en augmentant l'épaisseur de la troisième couche d'électrode supérieure produite au stade (e).

7. Procédé suivant l'une des revendications 1 à 6, dans lequel le stade (a) comprend les stades suivants, dans lesquels :
(a.1.) on dispose d'un substrat (100) ;
(a.2.) on produit l'électrode (112) inférieure sur au moins une partie du substrat (100) ;
(a.3.) on produit la couche (114) piézo-électrique sur au moins une partie de l'électrode (114) inférieure ; et
(a.4.) on produit la première couche (116a) d'électrode pour l'électrode (116) supérieure sur au moins une partie de la couche (114) piézo-électrique.

8. Procédé suivant la revendication 7, dans lequel le stade (a.1.) comprend la production d'un isolateur (108) acoustique sur ou dans le substrat (100) pour empêcher que l'oscillation acoustique ne se propage dans le substrat (100).

9. Procédé suivant la revendication 7 ou 8, dans lequel l'électrode (112) inférieure est une électrode (112a, 112b) à une seule couche ou à plusieurs couches.

10. Procédé suivant l'une des revendications 7 à 9, dans lequel on produit la première couche (116a) d'électrode supérieure en un matériau étanche acoustiquement et dans lequel on produit la deuxième couche (116b) d'électrode supérieure en un matériau dont la densité acoustique est comparable à celle du matériau de la première couche (116a) d'électrode supérieure.

11. Procédé suivant la revendication 10, dans lequel on produit l'électrode (116) supérieure et/ou l'électrode (112) inférieure en aluminium et/ou en tungstène.

12. Procédé suivant l'une des revendications 1 à 11, dans lequel on produit une multiplicité de circuits oscillants piézo-électriques sur une tranche, dans lequel, on produit de manière structurée au stade (a) sur la tranche la au moins une première couche (116a) d'électrode supérieure pour un certain nombre de circuits oscillants piézo-électriques, dans lequel au stade (b) on applique la première correction de fréquence sur toute la tranche, dans lequel au stade (c) on produit de manière structurée la au moins deuxième couche (116b) d'électrode supérieure pour tous les circuits oscillants piézo-électriques et dans lequel au stade (d) on applique la deuxième correction de fréquence sur toute la tranche.

13. Procédé suivant la revendication 12, dans lequel la première correction de fréquence et la deuxième correction de fréquence comprennent l'usinage pas à pas de diverses zones de la tranche.

14. Circuit oscillant piézo-électrique, qui a été produit suivant un procédé suivant l'une des revendications 1 à 13.

15. Dispositif de filtrage ayant un ou plusieurs circuits oscillants piézo-électriques suivant la revendication 14.
